Europäisches Patentamt

European Patent Office

Office européen des brevets

(11) Publication number: **0 139 233**
**B1**

# EUROPEAN PATENT SPECIFICATION

(45) Date of publication of patent specification: **27.05.87**

(21) Application number: **84111285.7**

(22) Date of filing: **21.09.84**

(51) Int. Cl.⁴: **C 23 C 18/24, C 23 C 18/38** //
**C03C17/10, B32B15/08**

(54) **Method for conditioning a surface of a dielectric substrate for electroless plating.**

(30) Priority: **11.10.83 US 540962**

(43) Date of publication of application:
**02.05.85 Bulletin 85/18**

(45) Publication of the grant of the patent:
**27.05.87 Bulletin 87/22**

(84) Designated Contracting States:
**DE FR GB**

(56) References cited:
**EP-A-0 100 452**
**DE-A-3 137 587**

(73) Proprietor: **International Business Machines
Corporation
Old Orchard Road
Armonk, N.Y. 10504 (US)**

(72) Inventor: **Bupp, James R.
2913 Twilight Drive
Endwell, NY 13760 (US)**
Inventor: **Lemon, Gary Kevin
3606 Dean Drive
Endwell, NY 13760 (US)**
Inventor: **Markovich, Voya
3611 Jowel Drive
Endwell, NY 13760 (US)**
Inventor: **Sambucetti, Carlos J.
4 Sassi
Croton-on-Hudson, NY 10520 (US)**
Inventor: **Tisdale, Stephen L.
409 Gates Road
Vestal, NY 13850 (US)**
Inventor: **Trevitt, Donna J.
208 Greenlawn Road
Vestal, NY 13850 (US)**

(74) Representative: **Suringar, Willem Joachim
Intellectual Property Department IBM Nederland
N.V. Watsonweg 2
NL-1423 ND Uithoorn (NL)**

Courier Press, Leamington Spa, England.

EP 0 139 233 B1

## Description

### Background of the invention

The invention relates to a method for conditioning at least one surface of a dielectric substrate for electrolessly plating a conductive metal thereon.

The process of electrolessly plating a metal (copper) onto a dielectric substrate is described for example in U.S. Patent RE 28,042 to Rhodenizer. One of the steps in this process is the seeding or catalyzing of the substrate surface prior to deposition of the metal onto the surface. This step is necessary since dielectric substrates are non-conductive.

Among the more widely employed procedures for catalyzing a substrate is the treatment of the surface with a stannous chloride sensitizing solution and a palladium chloride activator. For instance, one method for catalyzing a dielectric substrate is exemplified by U.S. Patent 3,011,920 to Shipley which includes sensitizing the substrate by first treating it with a solution of a colloidal metal, accelerating the treatment with a selective solvent to remove protective colloids from the sensitized dielectric substrate and then electrolessly depositing a metal coating on the sensitized substrate; for example, with copper from a solution of a copper salt and a reducing agent.

U.S. Patents 4,008,343 to Cohen et al and 3,562,038 to Shipley, Jr. et al also relate to methods for catalytically activating a surface with solutions containing Pd and Sn salts.

There have also been suggestions in the patent literature of treating substrates with certain surfactants. In particular, U.S. Patent 4,301,190 to Feldstein suggests a pre-treatment of a substrate with an "adsorption modifier" to enhance the attachment of the substrate of a non-noble metal catalyst. Certain surfactants, hydride oxide sols and certain complexing agents are suggested as "adsorption modifiers".

U.S. Patent 3,563,784 to Innes et al suggests a method of pretreating nonconductors for plating including a step of treating the surface with certain monofunctional surfactants, rinsing, and then activating either by a "two-step stannous chloride-palladium chloride treatment of one-step acid, tin-palladium hydrosol, treatment".

U.S. Patent 3,684,572 to Taylor relates to a method of plating non-conductors including steps of treating the surface of the non-conductors with certain quaternary amine monofunctional or single charged surfactants after etching and before catalyzing the surface.

U.S. Patent 3,573,937 to Drotar et al relates to a process for plating a non-conductive substrate. Reference is made therein to a step of rinsing the substrate with certain detergents before sensitizing with stannous chloride and activating with palladium chloride.

U.S. Patents 3,515,649 to Hepfer; 3,877,981 to Arnold; 3,930,072 to Wilks are of interest in showing the use of surfactants in plating processes in steps prior to the deposition of a catalyst. The above cited U.S. Patent 4,008,343 to Cohen et al suggests a process for electroless deposition wherein the catalytically prepared surface is rinsed with an aqueous acid solution with a pH of less than 1.5. The acid used is hydrochloric acid, perchloric acid, or nitric acid.

U.S. Patent 3,491,922 to Wilson describes the application of a cationic film forming resin, specifically melamine-formaldehyde resins, polyalkylene-amines, alkylated-methylol-melamines, triazine-formaldehyde and urea-formaldehyde resins, onto substrate surfaces to be subsequently plated.

EP—A—100,452 (which forms part of the state of the art within the meaning of Art. 54(3) and (4) EPC) discloses a method for conditioning surfaces of dielectric substrates for the electroless plating in which a copolymer of a non-reactive backbone chain of polyacrylamide to which are attached short chains of a tetra-alkyl-ammonium compound, with multiple charge functionality dissolved in a diluted inorganic acid, such as hydrochloric acid, is applied to the substrate surface prior to the activation.

Especially if the last of the cited methods is used, a very homogeneous metallization with excellent adhesion to the substrate is obtained. However if circuit lines are to be formed additively on the substrate surface (i.e., by forming a photoresist mask on the activated surface prior to plating), there is still the problem of residual resist (resist blistering) on the substrate surface after the developing step and the plated circuit lines tend to widen close to the substrate surface (line tailing).

Resist blistering can cause interruption in metal lines and line tailing can cause shorts between adjacent metal lines.

### Summary of the invention

The inventive method, as claimed, has for its principal object to provide an improved method for conditioning substrate surfaces for electroless plating, and in particular for selective electroless plating.

It is a further object of the inventive method to provide an effective process for prohibiting resist blistering and line tailing.

These objects are to be achieved without increasing the number of the necessary process steps.

These objects are achieved by a method as indicated at the beginning of this description comprising the steps:

Bringing at least one surface of a substrate into contact with a composition containing $H_2SO_4$ and a multifunctional cationic copolymer containing at least two available ionic moieties; and activating the surface by bringing it into contact with a composition containing palladium chloride and stannous chloride.

It appears that the replacement of the HCl used in the above cited EP—A—100,452 by $H_2SO_4$ is responsible for the factual elimination of resist blistering and line tailing by the inventive method.

The inventive method is preferably applied in processes for producing metal circuits on substrates of glass, thermoplastics and thermosetting resins, such as epoxy cards and boards. The method is also applied in reworking substrates having already undergone copper plating and having been rejected due to failures.

Advantageous embodiments of the invention are disclosed in the claims.

Description of the preferred embodiment

The invention will become more apparent from the following detailed description.

The inventive method is applicable to conditioning a wide variety of dielectric substrates for electroless plating metals, such as copper. Dielectric substrates including thermoplastic or thermosetting resins and glass may be treated in accordance with the present invention.

Typical thermosetting polymeric materials include epoxy, phenolic base materials and polyamides. The dielectric materials may be molded articles of the polymers containing fillers and/or reinforcing agents such as glass filled epoxy or phenolic based materials. Examples of some suitable thermoplastic polymeric materials include polyolefins, such as polypropylene, polysulfones, polycarbonates, nitrile rubbers and ABS (acrylonitrile-butadiene-styrene) polymers.

The term "surface" as employed herein refers to the surfaces inside through-holes as well as to major surfaces of the subtrate. For instance, the present invention is useful for seeding the plated through-holes where the circuitry is being applied by either additively plating upon a thin layer of peel-apart copper or by a subtractive process. Also the present invention is useful for seeding in an electroless direct bond (EDB) process. In this case the circuitry is additively plated both in the holes and on the areas of the surface exposed in the openings of a photoresist mask selectively applied to the substrate surface.

Prior to the initiation of the inventive method, the through-holes used to receive the vias connecting different levels of circuitry are made, if required, and the dielectric with the through-holes is suitably cleaned and preconditioned. For instance, the preconditioning can include creation of active sites by physical means such as sand and/or vapor blasting and/or chemical methods such as solvent swelling. A typical solvent is N-methylpyrrolidone. The substrate can also be pretreated with a sulfochromic acid composition.

If the inventive method is applied in a process for selectively electroless plating a metal, such as copper, onto the substrate surface, the following steps for preconditioning the surface are preferably applied.

Onto the surface of the dielectric substrate a metal sheet having a roughened surface is laminated by pressing the roughened surface of that metal sheet against the surface. The metal sheet has a thickness of about 25.4 µm. Subsequently the metal sheet is completely etched off. Apparently at this stage of the process anchor points for the copper have developed at the surface to be plated. These anchor points facilitate the plating of the metal afterwards and improve its adhesion to the surface.

If through-connections are formed in the substrate (e.g., if printed circuits on both sides of a flat substrate have to be connected), holes are now drilled through the substrate, preferably by a laser beam or by mechanical drilling. Subsequently the holes are cleaned either by vapor blasting or chemical methods, such as solvent swelling. It is also possible to produce the holes prior to the removing of the copper sheet.

The next step is a cleaning step, where the substrate is preferably cleaned for about five minutes at a temperature of between 45°C and 60°C with an alkaline cleaner consisting of a solution containing sodium phosphate and sodium silicate and having a pH value of 13. The cleaner is rinsed off with deionized water having a temperature of between 45°C and 60°C.

In accordance with the present invention the substrate is treated with an aqueous solution containing $H_2SO_4$ and a multifunctional cationic copolymer. The copolymer is a multifunctional cationic material in that it contains at least two active or available cationic functional moieties. The preferred ionic moieties are quaternary phosphonium and quaternary ammonium groups. Copolymers containing at least two cationic moieties are commercially available and need not be described herein in detail. Examples of commercially available multifunctional cationic copolymers are Reten® 210 and Reten® 220, available from Hercules, description of which can be found in "Water-soluble Polymers", Bulletin VC-482A, Hercules Inc., Wilmington, Delaware 19899, U.S.A.

Reten® 210 is in powder form and is a copolymer of acrylamide and betamethacryloxyethyltrimethylammonium methyl sulphate, having a Brookfield viscosity in a 1% solution of 600—1000 cps (0.6—1 Pa · s).

Reten® 220 is in powder form and is a copolymer of acrylamide and betamethacryloxyethyltrimethylammonium methyl sulphate, having a Brookfield viscosity in a 1% solution of 800—1200 cps (0.8—1.2 Pa · s).

The molecular weights of the Reten polymers are usually relatively high and vary from about 50,000 to about 1,000,000 or more. These high molecular weight polymers are solid products and their main chemical backbone structure is polyacrylamide. To the polyacrylamide various tetra alkyl ammonium compounds can be attached. These quaternary ammonium groups provide the number of positive charges of the polymer.

The cationic copolymer is employed as a dilute aqueous solution of 0.01 to 1% by weight and preferably 0.05 to 0.5% by weight of the copolymer. The aqueous solution also contains sulfuric acid to provide a pH value of 0 to 3 and preferably about 1. Low pH values are preferred in order to obtain a relatively low viscosity for the polymer solution to facilitate application of the polymer. The acid is usually present in amounts of about 2 to 4% by weight, 2% by weight being preferred.

The treatment with the cationic copolymer requires generally one to ten minutes and preferably one minute to two minutes. The multifunctional cationic copolymer provides a surface of a positive polarity while the catalyst particles to be subsequently applied to the substrate have a negative polarity. This difference in polarity provides for electrostatic attraction of the catalyst particles.

After the substrate is contacted with the cationic copolymer composition, the substrate is rinsed to remove any excess copolymer not adsorbed by the substrate surface.

Next the substrate surface and/or through-hole surface are activated by means of a colloidal solution containing palladium chloride, stannous chloride and hydrochloric acid. The activation serves to initiate the electroless plating process. The surfaces are brought into contact with the colloidal solution preferably for five minutes, however the contact time can vary between one and ten minutes. To produce the seeder bath two solutions (A and B) are prepared. About 60 kg of $SnCl_2 \cdot 2H_2O$ are dissolved in 20 liters of concentrated (37%) HCl with stirring. It is very important to dissolve the $SnCl_2 \cdot 2H_2O$ in concentrated HCl. Under these conditions no hydrolysis of the Sn-salt takes place. When the salt is totally dissolved, more 37% HCl is added until a volume of 50 liters is reached (solution A). About 1 kg of $PdCl_2$ is dissolved in 15 liters of 37% HCl. This solution is diluted with deionized water until a volume of 50 liters is reached (solution B). Solution B is added slowly to solution A with stirring. The mixture is boiled for two hours. Ater cooling about 70 g of a fluorocarbon surfactant, such as FC-95 marketed under this tradename by the Minnesota Mining and Manufacturing Co. and consisting of a perfluoro alkylsulfonate, are added. This solution can be stored for several months. To prepare the actual seeder bath about 130 ml of this solution and about 175 g of NaCl are taken to a volume of one liter by adding deionized water. This seeder bath contains per liter solution about 80 g of $SnCl_2 \cdot 2H_2O$, about 1.2 g $PdCl_2$, about 85 ml of 37% HCl, about 0.09 g of FC-95 and the NaCl. In order to replenish the seeder after it is used for some time, fresh solution can be added. It was found that the seeder bath works satisfactorily if the amount of $SnCl_2 \cdot 2H_2O$ varies between 80 g and 150 g, of $PdCl_2$ between 1.2 g and 2.6 g and of HCl between 85 ml and 300 ml per liter of solution.

It contains colloidal particles having a nucleus of palladium and tin in the weight ratio of 1:3 and a shell of chloride ions.

The surfaces are brought into contact with the colloidal solution at room temperature for five minutes, however the contact time can vary between one minute and ten minutes.

The colloidal particles, having a shell of negative chloride ions, adhere by means of electrostatic attraction to the dielectric surface having positive charges due to the treatment with Reten.

Onto the conditioned surfaces a metal, such as nickel or copper, is plated without further treatment prior to the plating except for air drying. The conditioned surfaces may be washed with deionized water, treated with diluted HCl and dried at elevated temperatures prior to the plating. In addition to these process steps, photoresist masks corresponding to the negative of desired metal and patterns may be formed on the activated surfaces prior to the plating. The washing, HCl treatment and drying step sequence is especially important if a photoresist mask is applied prior to plating.

Plating without further preceding treatments is particularly applicable, if the conditioned surfaces are restricted to the through-holes. Metals such as nickel or copper are plated by electroless plating onto the treated surface until the desired thickness is reached. The preferred metal employed is copper. The preferred copper electroless plating bath and the method of application are disclosed in U.S. Patents 3,844,799 and 4,152,467.

The copper electroless plating bath is generally an aqueous composition which includes a source of cupric ion, a reducing agent, a complexing agent for the cupric ion and a pH adjuster. The plating bath also preferably includes a cyanide ion source and a surface active agent.

The cupric ion source generally used is a cupric sulphate. It is preferred to use from 8 to 12 g/liter and most preferably 10 g/liter. The most common reducing agent employed is formaldehyde which is preferably used in amounts from 0.7 to 7 g/liter and most preferably from 0.7 to 2.2 g/liter. The most common complexing agent is ethylene diamine tetraacetic acid (EDTA). The amount of complexing agent is dependent upon the amount of cupric ions present in solution and is generally from 20 to 50 g/liter, or in a 3—4 fold molar excess. The plating bath can also contain a surfactant which assists in wetting the surface to be coated. A satisfactory surfactant is, for instance, an organic phosphate ester available under the trade designation Gafac® RE-610. Generally the surfcatant is present in amounts from 0.02 to 0.3 g/liter.

In addition, the pH of the bath is also generally controlled, for instance, by the addition of a basic compound such as sodium hydroxide or potassium hydroxide in the desired amount to achieve the desired pH. The preferred pH of the electroless plating bath is between 11.6 and 11.8. Also, preferably, the plating bath contains a cyanide ion in the form of sodium cyanide or ammonium cyanide. The amount is preferably between 10 and 25 mg/liter to provide a cyanide ion concentration in the bath within the range of 0.0002 to 0.0004 molar. The temperature of the bath is preferably maintained between 70°C and 80°C and most preferably between 70°C and 75°C. Also, it is preferred to maintain the $O_2$ content of the bath between 2 and 4 ppm and preferably between 2.5 and 3.5 ppm. The $O_2$ content can be controlled by injecting oxygen and an inert gas into the bath.

The treatments enumerated above prior to the plating are useful in those cases where metal is plated continuously or selectively onto the major surfaces of the substrates. The enumerated process steps are described hereinbelow in more detail:

The substrates are rinsed with deionized water. Due to the sudden change of the pH value, most of the chloride ions are replaced by $OH^-$ ions. Subsequently the substrates are treated with 8% HCl, where tin is selectively removed from the substrate surface. This leaves enriched Pd regions with an increased catalytic effect in the plating process. (The amount of Sn is less than 1 µ g/cm² by the HCl treatment whereas the amount of Pd is of the order of 3—4 µ g/cm²).

After another rinse with deionized water, the substrates are dried in an oven for 30 minutes at a temperature between 60 and 70°C or in a vacuum oven at about 100°C. In the drying operation all the water is driven off irreversibly from the colloidal particles leaving a shell of oxygen in the form of insoluble tin oxide.

If it is intended to produce a blanket metal coating on the substrate surface, the next step is the electroless plating as described above. If the metal is to be applied in an additive process, onto the dried substrate surface a photoresist layer is applied, either by spin-coating or, preferably, by laminating a photoresist foil onto the substrate surface. Such a foil is a negative photoresist and is marketed by DuPont under the type designation T-168.

By exposure through an appropriate mask exactly aligned to the substrate and subsequent developing, the negative of the desired circuit pattern is produced by the photoresist foil. In the areas corresponding to the desired pattern where the photoresist has been removed in the development step, the catalyzed regions of the substrate surface are exposed. The photoresist process has no detrimental effect on the catalyzed surfaces including the surfaces in the through-holes. No resist blistering is determined in the areas corresponding to the desired pattern.

Next the metal is plated by electroless plating onto the exposed surface areas. The plating process is described hereinbelow with copper as the metal. However, the process is transferable to other metals as well. The plating is done in two steps differing in the composition of the baths used and in the duration of the steps.

Both baths contain in one liter of solution 8 to 10 g copper sulphate, 35 to 55 g ethylene diamine tetraacetic acid (EDTA), 2 to 3 ml formaldehyde and 0.02 to 0.03 g of a surfactant. The surfactant assists in wetting the surfaces to be coated. A satisfactory surfactant is, for example, an organic phosphate ester available under the trade designation Gafac® RE-610. The preferred pH value of the electroless plating bath is between 11.6 and 11.8 at a temperature of 25°C. The bath used in the first plating step contains no cyanide which permits an oxygen level below 2 ppm. No gas, like air, is bubbled through the bath.

$CN^-$ and $O_2$ form soluble complex ions with Pd. The lower limit of the $O_2$ content can be controlled by injecting oxygen and an inert gas into the bath. The bath used in the second plating step contains 10 to 20 ppm cyanide and its oxygen content is about 3 ppm, which is achieved by bubbling air through the bath. It is not necessary to remove the substrates from the first bath and put them in the second. It is also possible to transform the first bath into the second by adding sodiumcyanide and bubbling air through the bath after the first plating period.

The plating takes place at a temperature between 70 and 80°C and preferably between 70 and 75°C where the substrate is plated in the first step from 15 to 30 minutes and in the second plating step from 10 to 20 hours. The plated copper is between 37.5 and 50 µm thick.

With the inventive method a homogeneous coverage of all the substrate surface areas exposed including the through-holes is achieved. The thickness of the plated copper is essentially homogeneous and its adhesion to the substrate is excellent. After the plating the photoresist is stripped, preferably with methylene chloride or a similar solvent, and the pD in the areas not plated with copper is removed by a treatment with a chlorite solution.

The inventive method is applicable especially in processes for producing metal circuits on substrates such as thermosetting and thermoplastic resins and of glass. The method is especially useful for producing high quality copper plated epoxy boards and cards.

The inventive method is also very advantageously applied in processes for reworking substrates that have already undergone electroless plating and eventually soldering, are structurally sound, but have then been rejected due to defects, such as opens or plating voids, solder defects and scratches on the circuitry. The substrates to be reworked are selectively covered with a metal, such as copper, and sometimes also selectively with photoresist and/or tin.

In the first step of the reprocessing the photoresist is stripped, preferably with methylene chloride or a similar organic solvent, and subsequently the substrate are dried. Then the metal applied by plating and, if present, the tin is removed by etching. If the metal is copper, preferably a $CuCl_2HCl$ solution is used, since this agent etches copper and also tin. At this stage the surface of the substrates apparently exhibits the roughness that is produced in the method described above by laminating a copper sheet with a roughened surface to the substrate surface to be plated and subsequently etching off the copper sheet. From this point on the reprocessing proceeds as described above (e.g., with the process steps of rinsing with an alkaline solution, conditioning the surface with a Reten solution, seeding the surface with palladium/tin salts in a single seed process, rinsing with deionized water, accelerating by removing most of the tin with a 8%-HCl-solution, forming a photoresist mask corresponding to the negative of the desired circuit pattern and finally the selective electrolessly metal plating).

The following two examples serve to illustrate preferred embodiments of the inventive method and are not intended to limit the teachings as set forth herein.

Example I

A glass substrate previously cleaned in alcohol is immersed for about three minutes into a bath of 2% $H_2SO_4$ aqueous solution containing 0.05 g of Reten® 210 per liter. The substrate is then rinsed with deionized water and dried with air. Next, the coated substrate is immersed in a bath of 1.5 g per liter of $PdCl_2$, 100 g per liter of $SnCl_2$, 106 milliliters per liter of 37% HCl and 0.1 g of surfactant at room temperature for three minutes. The substrate is then air dried. The substrate has a very visible Pd catalytic film thereon. Subsequently the substrate is rinsed in deionized water, treated with 8% HCl at room temperature for ten minutes, rinsed with deionized water for 3 minutes at room temperature and then vacuum dried for 30 minutes at 100°C. Onto the dried substrate a layer of T-168 photoresist is laminated. An illumination mask the masked areas of which correspond to the negative of the desired circuit pattern is aligned to the substrate and then the substrate is irradiated through the mask. The developing is followed with a trichloroethane type developer where the seeded areas of the substrate to be plated and corresponding to the desired pattern are exposed. In the areas corresponding to the desired pattern, no resist blistering is detected.

The substrate is then immersed in a copper electroless additive plating bath for about ten minutes. The electroless plating bath contains about 20 g/liter of $CuSO_4 \cdot 5H_2O$, 35 g/liter of EDTA dihydride, 0.25 g/liter of Gafac® RE-610, 14 mg/liter sodium cyanide, and 2 ml/liter of 37% HCHO. The pH of the bath is 11.7 by the addition of NaOH and the temperature of the bath is 73°±5°C. The $O_2$ content of the bath is maintained at 2.5 to 3.5 ppm. The gas flow rate is about 340 standard litres/minute (12 standard cubic feet/minute). In addition the plating racks are continuously agitated during the plating.

The substrate, after plating, has a pattern of continuous copper film on the substrate surface. The produced copper lines show no line tailing.

Example II

Onto a substrate consisting of an epoxy resin a 25.4 µm thick copper sheet having a roughened surface is laminated, by pressing. Into the etched substrate through-holes for producing vias are laser drilled and then cleaned by vapor blasting. The substrate is treated with an aqueous solution containing sodium phosphate and sodium silicate and having a pH value of about 13. The substrate is rinsed with deionized water at a temperature of 50° for two minutes. Subsequently the substrate is immersed for two minutes in a 0.05% solution of Reten 210 in 2% $H_2SO_4$ having a pH value of 1. After another rinse in warm deionized water, the substrate is immersed in a seeder bath containing per liter of solution 1.2 g of $PdCl_2$, 80 g of $SnCl_2 \cdot 2H_2O$, 85 ml of 37% HCl, 0.1 g of the surfactant and 175 g of NaCl with the rest being water. The solution is prepared as described above.

The substrate is immersed in the seeding bath that has room temperature for three to five minutes. Subsequently the substrate is rinsed in deionized water, treated with 8% HCl at room temperature for ten minutes, rinsed with deionized water for three minutes at room temperature and then vacuum dried for 30 minutes at 100°C. Onto the dried substrate a layer of T-168 photoresist is laminated. An illumination mask, the mask area of which corresponds to the negative of a desired circuit pattern, is aligned with the substrate and then the substrate is irradiated through the mask. The developing is performed with a trichloroethane type developer where the seeded areas of the substrate to be plated and corresponding to the desired pattern are exposed. In the areas corresponding to the desired pattern no resist blistering is detected.

Next the exposed areas of the substrate are electrolessly copper plated. There the substrate is first immersed for 30 minutes in a bath having a temperature of 72±2°C and containing per liter of solution 8—10 g $CuSO_4$, 35—55 g EDTA, 0.1 g Gafac wetting agent, 2—3 ml formaldehyde and less than 2 ppm of oxygen with the rest being water. The bath has a pH value of 11.7 (at 25°C). Then the substrate is immersed in a second bath that has the same composition as the first bath except that its oxygen content is 3 ppm and it contains 10—20 ppm cyanide. In this bath, also at a temperature of 72±2°C, the substrate remains 15 hours. The thickness of the plated copper is about 50.8 µm. Finally the photoresist mask is stripped with methylene chloride.

The visual impression of the plated copper is excellent. All the exposed areas of the substrate including the through-holes are covered by a continuous copper film, the thickness of which is essentially homogeneous; and it has a very good adhesion. The copper lines show no line tailing.

**Claims**

1. Method for conditioning at least one surface of a dielectric substrate for electrolessly plating of a conductive metal thereon comprising:

bringing said at least one surface into contact with a composition containing $H_2SO_4$ and a multifunctional cationic copolymer containing at least two available cationic moieties and wherein said composition has a pH value of between 0 and 3, and then activating the surface by treating it with a colloidal solution containing palladium chloride, stannous chloride and HCl.

2. Method according to claim 1 wherein a copolymer of polyacrylamide forming the inert backbone and functionally active tetra alkyl ammonium compounds in a $H_2SO_4$ solution is used for contacting said surface.

3. Method according to claim 2 wherein a 0.05 to 0.5 weight percent solution of the copolymer in $H_2SO_4$ with the solution having a pH value of between 0 and 3 is used for contacting said surface.

4. Method according to claim 2 or 3 wherein a copolymer of polyacrylamide and betamethacryloxyethyltrimethylammonium methyl sulphate in a $H_2SO_4$ solution is used for contacting said surface.

5. Method according to a previous claim wherein the surface brought into contact with the cationic copolymer is activated with a colloidal solution prepared from a mixture formed by mixing a solution of $SnCl_2 \cdot 2H_2O$ in 37% HCl and a solution of $PdCl_2$ in diluted HCl, boiling for two hours and adding a surfactant and containing per liter of solution 600 g of $SnCl_2 \cdot 2H_2O$, 10 g of $PdCl_2$, 650 ml of 37% HCl and 0.7 g of a surfactant, by diluting fixed amounts of said mixture with deionized water, the colloidal solution containing per liter 1.2—2.6 g of $PdCl_2$, 80—150 g of $SnCl_2 \cdot 2H_2O$, 85—300 ml of 37% HCl and 0.09—0.16 g of the surfactant.

6. Method according to a previous claim used for conditioning said surface of a dielectric substrate for electroless plating with copper thereon.

7. Method according to claim 6 wherein prior to conditioning said at least one surface, a copper plate is laminated to said surface and subsequently removed by etching and wherein after the activation of said surface said activated surface is rinsed with deionized water, brought into contact with an aqueous solution of HCl, rinsed again and dried at elevated temperatures, a photoresist layer is applied to said at least one dried surface and is exposed to selective radiation and developed, and plating said at least one selectively masked surface by contacting it for a period of from 15 to 30 minutes with a first plating bath containing $CuSO_4$, a complexing agent, HCHO and a surfactant with the oxygen content being less than 2 ppm and then for a period of from 10 to 20 hours with a second plating bath differing from the first plating bath by an increased oxygen content of 3 to 4 ppm and an NaCN content of 10 to 20 ppm.

8. Method according to a previous claim wherein said dielectric substrate consists of a thermosetting or thermoplastic resin or of a glass for the electroless plating of conductive metal thereon.

9. Method according to claim 8 wherein at least one surface of a dielectric is conditioned for electroless plating of copper.

10. Method according to claim 2 wherein the pH value of the solution is between 0 and 2, and preferably is about 1.

## Patentansprüche

1. Verfahren zum Konditionieren wenigstens einer Oberfläche eines dielektrischen Substrates für die stromlose Plattierung mit einem leitenden Metall mit den Verfahrensschritten:

In-Kontakt-Bringen der wenigstens einen Oberfläche mit einer Mischung, die $H_2SO_4$ und ein multifunktionelles kationisches Kopolymer enthält, das wenigstens zwei aktive kationische Komponenten enthält, wobei die Mischung einen pH-Wert zwischen 0 und 3 hat, und danach Aktivieren der Oberfläche, indem sie mit einer kolloidalen Lösung behandelt wird, die Palladiumchlorid, Zinndichlorid und HCl enthält.

2. Verfahren nach Anspruch 1, bei dem ein Kopolymer aus Polyakrylamid die inerte Hauptkette bildet und funktionell aktive Tetraalkylammoniumverbindungen in einer $H_2SO_4$-Lösung zum In-Kontakt-Bringen der Oberfläche verwendet wird.

3. Verfahren nach Anspruch 2, bei dem eine Lösung mit 0.05 bis 0.5 Gewichtsprozent des Kopolymers in $H_2SO_4$ wie die einen pH-Wert zwischen 0 und 3 aufweisende Lösung zum Kontaktieren der Oberfläche verwendet wird.

4. Verfahren nach Anspruch 2 oder 3, bei dem ein Kopolymer des Polyakrylamides und Betamethakryloxyäthyltrimethylammonium-Methylsulfat in einer $H_2SO_4$-Lösung verwendet wird, um die Oberfläche zu kontaktieren.

5. Verfahren nach einem der vorstehenden Ansprüche, bei dem die mit dem kationischen Kopolymer in Kontakt gebrachte Oberfläche mit einer kolloidalen Lösung aktiviert wird, die aus einer Mischung zubereitet wird, die durch Mischen einer Lösung von $SnCl_2 \cdot 2H_2O$ in 37 %-iger HCl und einer Lösung von $PdCl_2$ in verdünnter HCl gebildet wird, wobei zwei Stunden lang gekocht wird und ein oberflächenaktiver Stoff hinzugefügt wird, und die pro Liter Lösung 600 g $SnCl_2 \cdot 2H_2O$, 10 g $PdCl_2$, 650 ml 37 %-iger HCl und 0,7 g eines oberflächenaktiven Stoffs enthält, indem bestimmte Mengen dieser Mischung mit deionisiertem Wasser verdünnt werden, wobei die kolloidale Lösung pro Liter 1,2 bis 2,6 g $PdCl_2$, 80 bis 150 g $SnCl_2 \cdot 2H_2O$, 85 bis 300 ml 37 %-iger HCl und 0,09 bis 0,16 g des oberflächenaktiven Stoffes enthält.

6. Verfahren nach einem der vorstehenden Ansprüche zum Konditionieren der Oberfläche eines dielektrischen Substrates für eine stromlose Beschichtung mit Kupfer.

7. Verfahren nach Anspruch 6, bei dem vor dem Konditionieren der wenigstens einen Oberfläche eine Kupferschicht auf die Oberfläche aufgebracht wird und anschließend durch Ätzen entfernt wird und wobei nach der Aktivierung der Oberfläche die aktivierte Oberfläche mit deionisiertem Wasser gespült wird, mit einer wässrigen Lösung von HCl in Kontakt gebracht wird, erneut gespült wird und bei erhöhten Temperaturen getrocknet wird, eine Photoresistschicht auf die wenigstens eine getrocknete Oberfläche aufgebracht wird, selektiver Strahlung ausgesetzt und entwickelt wird, wobei die wenigstens eine selektiv maskierte Oberfläche beschichtet wird, indem sie während 15 bis 30 Minuten mit einem ersten Beschichtungsbad, das $CuSO_4$, einen Komplexbildner, HCHO und einen oberflächenaktiven Stoff enthält, wobei der Sauerstoffgehalt weniger als 2 ppm beträgt, und danach für eine Zeit von 10 bis 20 Stunden mit einem zweiten Beschichtungsbad in Kontakt gebracht wird, das sich vom ersten Beschichtungsbad durch einen erhöhten Sauerstoffgehalt von 3 bis 4 ppm und einen NaCN Gehalt von 10 bis 20 ppm unterscheidet.

8. Verfahren nach einem der vorstehenden Ansprüche, bei dem das dielektrische Substrat aus einem wärmehärtbaren oder thermoplastischen Harz oder aus einem Glas für das stromlose Beschichten mit einem Metall besteht.

9. Verfahren nach Anspruch 8, bei dem die wenigstens eine Oberfläche eines Dielektrikums für das stromlose Beschichten mit Kupfer konditioniert wird.

10. Verfahren nach Anspruch 2, bei dem der pH-Wert der Lösung zwischen 0 und 2, vorzugsweise bei etwa 1 liegt.

## Revendications

1. Procédé pour le conditionnement d'au moins une surface d'un substrat diélectrique, pour le placage sans courant d'un métal conducteur sur cette surface, comprenant la mise en contact de ladite au moins une surface avec une composition contenant $H_2SO_4$ et un copolymère cationique multifonctionnel contenant au moins deux groupes cationiques disponibles, ladite composition ayant une valeur de pH comprise entre 0 et 3, puis l'activation de la surface par traitement de celle-ci avec une solution colloïdale contenant du chlorure de palladium, du chlorure stanneux et HCl.

2. Procédé suivant la revendication 1, dans lequel un copolymère de polyacrylamide, formant la structure principale inerte, et de composés de tétraalkylammonium fonctionnellement actifs dans une solution de $H_2SO_4$ est utilisé pour la mise en contact avec ladite surface.

3. Procédé suivant la revendication 2, dans lequel on utilise une solution de 0,05 à 0,5% en poids du copolymère dans $H_2SO_4$, la solution ayant une valeur de pH comprise entre 0 et 3, pour la mise en contact avec ladite surface.

4. Procédé suivant la revendication 2 ou 3, dans lequel on utilise un copolymère de polyacrylamide et de bêtaméthacryloxyéthyltriméthylammonium méthyl sulfate dans une solution de $H_2SO_4$, pour mise en contact avec ladite surface.

5. Procédé suivant une revendication précédente, dans lequel la surface mise en contact avec le copolymère cationique est activée avec une solution colloïdale préparée à partir d'un mélange obtenu par mélange d'une solution de $SnCl_2 \cdot 2H_2O$ dans HCl à 37% et d'une solution de $PdCl_2$ dans HCl dilué, ébullition pendant deux heures et addition d'un agent tensioactif, et contenant par litre de solution 600 g de $SnCl_2 \cdot 2H_2O$, 10 g de $PdCl_2$, 650 millilitres de HCl à 37% et 0,7 g d'un agent tensioactif, par dilution de quantités fixes dudit mélange au moyen d'eau déminéralisée, la solution colloïdale contenant par litre 1,2—2,6 g de $PdCl_2$, 80—150 g de $SnCl_2 \cdot 2H_2O$, 85—300 ml de HCl à 37% et 0,09—0,16 g de l'agent tensioactif.

6. Procédé suivant une revendication précédente, utilisé pour le conditionnement de ladite surface d'un substrat diélectrique pour le placage sans courant de cuivre sur cette surface;

7. Procédé suivant la revendication 6, dans lequel avant le conditionnement de ladite au moins une surface, une plaque de cuivre est laminée à ladite surface et enlevée ensuite par attaque, et dans lequel, après l'activation de ladite surface, cette surface activée est rincée à l'eau déminéralisée, mise en contact avec une solution aqueuse de HCl, à nouveau rincée et séchée à température élevée, une couche photosensible est appliquée à ladite au moins une surface séchée et elle est exposée à une irradiation sélective et développée, et le placage de ladite au moins une surface sélectivement masquée est effectuée par mise en contact de cette surface pendant une durée de 15 à 30 minutes avec un premier bain de placage contenant $CuSO_4$, un agent complexant, HCHO et un agent tensioactif, la teneur en oxygène étant inférieure à 2ppm, puis pendant une durée de 10 à 20 heures avec un deuxième bain de placage qui diffère du premier bain de placage par une plus grande teneur en oxygène, de 3 à 4 ppm, et une teneur en NaCN de 10 à 20 ppm.

8. Procédé suivant une revendication précédente, dans lequel ledit substrat diélectrique est constitué d'une résine thermodurcissable ou thermoplastique ou d'un verre pour le placage sans courant de métal conducteur sur ce substrat.

9. Procédé suivant la revendication 8, dans lequel ladite au moins une surface d'un diélectrique est conditionnée pour le placage sans courant de cuivre.

10. Procédé suivant la revendication 2, dans lequel la valeur de pH de la solution est comprise entre 0 et 2 et elle est de préférence de l'ordre de 1.